# EUROPEAN PATENT SPECIFICATION

(11) **EP 0 374 263 B1**
(45) Date of publication and mention of the grant of the patent: **03.01.1996**
(21) Application number: 89906475.2
(22) Date of filing: 06.06.1989
(51) Int. Cl.: C01G 3/00

(54) **OXIDE SUPERCONDUCTIVE MATERIAL AND PROCESS FOR ITS PRODUCTION**
SUPRALEITENDES OXIDMATERIAL UND VERFAHREN ZUR HERSTELLUNG
OXYDE SUPRACONDUCTEUR ET PROCEDE DE PRODUCTION

(30) Priority: 06.06.1988 JP 137464/88; 19.10.1988 JP 261607/88
(43) Date of publication of application: 27.06.1990
(73) Proprietor: NIPPON STEEL CORPORATION, Tokyo 100-71 (JP)
(72) Inventor: MORITA, Mitsuru, Nakahara-ku Kawasaki-shi Kanagawa 211 (JP); MIYAMOTO, Katsuyoshi, Nakahara-ku Kawasaki-shi Kanagawa 211 (JP); MURAKAMI, Masato, Nakahara-ku Kawasaki-shi Kanagawa 211 (JP); MATSUDA, Shoichi, Nakahara-ku Kawasaki-shi Kanagawa 211 (JP)
(74) Representative: Kador & Partner
(86) International application number: JP8900577
(87) International publication number: WO8912028

(56) References cited:
- APPLIED PHYSICS LETTERS, vol. 51, no. 22, 30th November 1987, pages 1854-1856, New York, US; A.M. HERMANN et al.: "Melt-processible rare earth-Ba-Cu-O superconductors based on molten Ba-Cu oxides"
- Japanese Journal of Applied Physics, Vol. 27, No. 4 (April 1988) (Toyko) (Preparation of High-Tc Superconducting Bi-Ca-Sr-Cu-O Ceramics by the Melt Quenching Method) p. L533 - L535
- Journal of the American Ceramic Society, Vol. 71, No. 5 (1988) PATRICIA A. MORRIS, et al. (Melt Growth of High-Critical-Temperature Superconducting Fibers) p. 334-337

## Description

### TECHNICAL FIELD

The present invention relates to an oxide superconductive material having a high critical current density even in a high magnetic field, and a process for the preparation of this oxide superconductive material by which a superconductive phase is obtained in a partially melted state at a high temperature.

### BACKGROUND ART

Current research into the utilization of oxide superconductive materials is directed to the sintering process (see Jap. J. Appl. Phys., Vol. 26, No. 5, 1987, pages L624 through L626). According to this process, starting powders (RE, that is, a rare earth element including Y and oxides or carbonates of Ba and Cu) are mixed at a predetermined composition of REBa₂Cu₃O₇, the mixture is calcined to form a calcined powder having a structure of REBa₂Cu₃O_{7-y} , and this calcined powder is then molded and sintered to obtain a superconductive material. As an application of this process, there can be mentioned research by Toshiba into the forming of a wire by packing the calcined powder into a metal cover or the like (Jap. J. Appl. Phys., Vol. 26, No. 5, 1987, pages L865 and L866). Moreover, a process has been attempted in which the calcined powder is molded into a plate and the plate is sintered to obtain a shielding material. These trials, however, have not been practically utilized because the critical current density of the sintered body is low.

The process in which the starting material is heat-melted at a high temperature and gradually cooled is not used for the preparation of a superconductive material, although used for the growth of a single crystal. In this case, in general, the starting powder containing a considerable excess of Cu or CuBa is grown in an alumina crucible. As a typical instance there can be mentioned research by NTT (Jap. J. Appl. Phys., Vol. 26, No. 5, 1987, pages L851 through L853).

In currently available superconductive materials such as sintered bodies, only current densities of several thousand A/cm are obtained at a temperature T of 77 K and an external magnetic field He of O T, and thus they cannot be put to practical use. For a practical utilization, the current density must be increased to about 10⁴ A/cm at a T of 77 K and an He of several T.

An object of the present invention is to improve the characteristics by using a melting process different from the conventional process for the production of a superconductive material, and to make it possible to practically utilize a superconductive material of the REBa₂Cu₃O_{7-y} phase (hereinafter referred to as "123 phase").

The main problems to be solved to enable a practical utilization are as follows.
1) Improvement of the current density (Jc) in a zero magnetic field and a magnetic field.
2) Improvement of the shapeability into a wire, a coil, a plate and the like.
3) Improvement of the mechanical strength.

In a sintered body obtained according to the conventional sintering process, since the particle size is as fine as several µm to several hundred µm, many grain boundaries exist in the interior of the sintered body. These grain boundaries have a weak superconductivity, and a large superconductive current in particles is restricted and reduced at the grain boundaries. Accordingly, in the sintered body, the Jc is small, and is greatly reduced to scores of A/cm in a magnetic field. Furthermore, processing of the sintered body after the sintering and bonding of sintered bodies, is very difficult, and moreover, the sintered body is defective in that it is inherently brittle.

### DISCLOSURE OF THE INVENTION

The present invention solves the foregoing problems and provides a high-quality oxide superconductive material and a process for the preparation thereof.

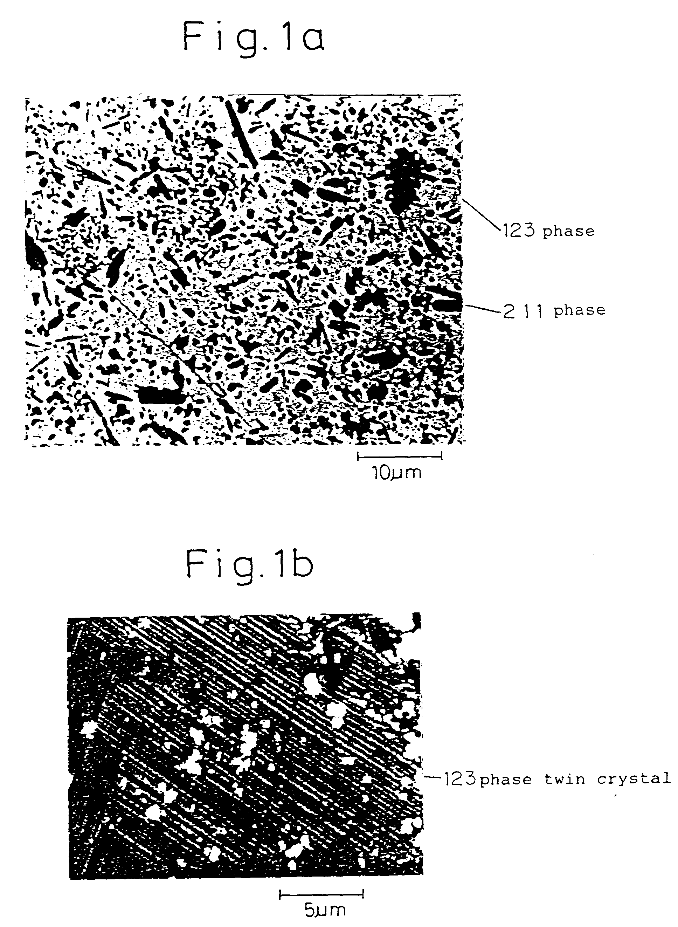

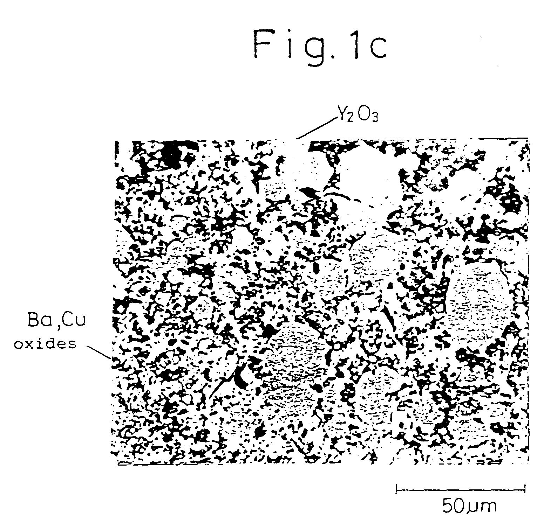

An oxide superconductive material having a high critical current density (Jc) in a zero magnetic field and a magnetic field has a texture as shown in Fig. 1(a). Namely, grains of the RE₂BaCuO₅ phase (hereinafter referred to as "211 phase") having a diameter smaller than 20 µm are dispersed in the texture of the REBa₂Cu₃O_{7-y} phase. The intermediate substance just after the solidification and before the heat treatment has a texture as shown in Fig. 1(c), and this intermediate substance is an oxide superconductive material having a texture in which grains of the RE₂O₃ phase having a diameter smaller than 50 µm are dispersed in BaCu oxide. The texture of the superconductive material of the present invention consists of single crystals of several mm containing a fine 211 phase, and these single crystals are regularly oriented to show a twin pattern as illustrated in Fig. 1(b). This texture is characterized in that the quantities of grain boundaries that reduce the Jc are very small. It is also seen that the 211 phase is present in the superconductive phase. The presence of a certain quantity of this 211 phase is necessary when obtaining a material in which the quantities of grain boundaries, cracks, and a second phase other than the 211 phase, for example, the CuO phase, are reduced, and preferably the 211 phase is finely dispersed. This texture is obtained by heating the intermediate having the texture shown in Fig. 1(c) at a temperature of 1000 to 1350°C, to grow a fine acicular 211 phase, and then splitting this 211 phase.

As the process for preparing an oxide superconductive material having the above-mentioned texture, there is provided a process in which a plate, coil or wire having a thickness of several mm,suitably below 5 mm, which is obtained by a rapid cooling from the molten state and contains oxides of RE, Ba and Cu elements, is heated to a partially melted state at a temperature of 1000°C to 1350°C and is gradually cooled, at a rate lower than 200°C/hr, to disperse many and fine grains of the 211 phase in a superconductive phase texture precipitated by peritectic reaction, whereby a high-Jc material is prepared by which the foregoing problems are solved.

The most prominent characteristic of the third aspect of the present invention is that a melt containing oxides of RE, Ba and Cu is rapidly cooled and solidified to obtain a plate or the like. In the plate or the like obtained by rapid cooling and solidification, RE₂O₃ and BaCu oxide are very finely and uniformly distributed, and by again heat-treating this plate or the like, a superconductive phase containing a fine and uniform 211 phase is obtained by the preparation process of the fourth aspect of the present invention, in which a molded body of RE oxide and BaCu oxide is subjected to a heat treatment. As the rapid cooling method, there can be mentioned the plasma spraying method, the laser irradiation method, and the hammer quenching method.

The gist of the fourth aspect of the present invention resides in a process for the preparation of a high-Jc material by which the foregoing problems are solved, in which a plate, coil or linear molded body having a thickness of several mm, which is obtained by mixing RE₂O₃ and BaCu oxide, is heated at a temperature higher than 1000°C and is gradually cooled, whereby a material having reduced quantities of grain boundaries and very close to a single crystal is obtained by utilizing a peritectic reaction from the high temperature side.

The most prominent characteristic of the fourth aspect of the present invention is that an oxide having a superconducting substance-forming composition, obtained by mixing RE₂O₃ with BaCu oxide, is used as the molded body and a superconductive phase containing a fine 211 phase, in which the number of cracks is reduced, is obtained by heat-treating this oxide. The inventors investigated the following three states as the state of the molded body before the heat treatment.
1. Molded body of REBa₂Cu₃O₇₋₇ phase powder
2. Powdery mixture of RE₂BaCuO₅ phase and BaCu oxide
3. Powdery mixture of RE₂O₃ and BaCu oxide As a result, it was found that, when a powdery mixture of RE₂O₃ and BaCu oxide is used as the molded body, a superconductive phase in which a fine 211 phase is uniformly distributed is obtained. It was also found that, in the obtained superconductive phase, the size of one grain is as large as several mm and the number of cracks is reduced, and a superconductive material in which superconductively weak links are reduced is obtained.

It was found that the reason for this is that, when the 211 phase is grown by the reaction between RE₂O₃ and the liquid (BaCu oxide), acicular 211 fibers having a fineness of about 1 µm are formed in the material.

The 123 phase is unstable at a high temperature of more than 970°C and is melt-decomposed into the 211 phase and the liquid phase (BaCu oxide). At a temperature of more than about 1250°C, the 211 phase is also decomposed into RE₂O₃ and the liquid phase. In the molded body heated at a high temperature, however, in the above-mentioned partially melted state the fibrous 211 phase absorbs the liquid phase, and therefore, the shape of the molded body is substantially retained. If the molded body in this partially melted state is gradually cooled, the 123 phase is formed by a peritectic reaction between the 211 phase and the liquid phase. The micro structure formed at this point is an aggregate of single crystals having a size of several mm, in which a fine 211 phase is contained. Accordingly, in the material prepared according to the present invention, the quantities of grain boundaries having a large inclination, which inhibit the manifestation of the Jc, are reduced and a high Jc can be obtained even in the absence of a magnetic field, and in a high magnetic field, a Jc 1000 times as high as the Jc obtained in the conventional technique can be obtained. Furthermore, in this preparation process, a molded body having a thickness smaller than 5 mm is once kept in the partially melted state at a temperature of 1000 to 1350°C, and since the molded body has an appropriate viscosity when heated at a high temperature, the molded body can be easily processed into an optional shape. Moreover, materials can be easily bonded to each other by keeping them in contact with each other.

The reason for limiting the thickness of the plate or the like is that, if the thickness exceeds 5 mm, an uneven distribution of the respective components becomes conspicuous in the partially melted state and a homogeneous material cannot be obtained. Therefore, the thickness is limited as mentioned above.

The reason for limiting the temperature for heating the plate or the like is that, if the temperature is lower than 1000°C a partial melting occurs but is quantitatively small, and the above-mentioned effect cannot be obtained, and that if the temperature is higher than 1350°C, the original shape of the plate or the like cannot be retained. This temperature is changed to some extent according to the kind of RE element and the composition charged in the heating atmosphere, and the temperature tends to shift to the high temperature side when the ion radius of the RE element is larger, the partial pressure of oxygen in the atmosphere is higher, or the amount of RE is greatly in excess.

The reason for limiting the rate of gradual cooling is that, if the gradual cooling rate is higher than 200°C/hr, the growth of grains of the 123 phase is not satisfactory, the quantities of grain boundaries increase, and the Jc is reduced. By this heat treatment, a fine 211 phase is included in the superconductive phase, and therefore, the texture is fine and the mechanical strength is improved.

The effects of the third and fourth aspects of the present invention are equivalent to the results obtained in the example given hereinafter.

### BRIEF DESCRIPTION OF THE DRAWINGS

Figure 1 is a microscope photo showing the micro structure of the superconductive material of the present invention, in which (a) shows the micro structure of the superconductive material, (b) shows the twin crystal of the superconductive material, and (c) shows the micro structure of the intermediate substance of the superconductive material;
Fig. 2 is a diagram illustrating the magnetic field dependency of the critical current density at the liquid nitrogen temperature of 77 K;
Fig. 3 is a diagram illustrating the magnetic field dependency of the Jc at the liquid helium temperature of 4.2 K; and
Fig. 4 shows the magnetic field dependency of the critical current density determined from the magnetization characteristics at 77 K.

### BEST MODE OF CARRYING OUT THE INVENTION

The best mode of carrying out the present invention will now be described with reference to the following example.

### Example

The process for the preparation of an oxide superconductive material according to the third aspect of the present invention is explained. A plate having a thickness of 1 mm, a width of 10 mm, and a length of 20 mm, which was obtained by melting a powder of YBa₂Cu₃O_{7-y} and hammer-quenching the melt, was used as the molded body. The results of the observation of the micro structure of this material are shown in Fig. 1(c). In this micro structure, Y₂O₃ having a size smaller than 50 µm was dispersed in BaCu oxide, the molded body was placed on a platinum net, and the following heat treatment was carried out in an oxygen current. The molded body was maintained at 1200°C for 1 hour, the temperature was lowered to 900°C at a rate of - 30°C/hr, and the temperature was then lowered to room temperature at a rate of - 100°C/hr. A sample was cut from the obtained material and the superconductive characteristics were determined to obtain the results shown below.

### Critical temperature (Tc):

A sharp superconductive transition was manifested at 93 K.

### Critical current density (Jc):

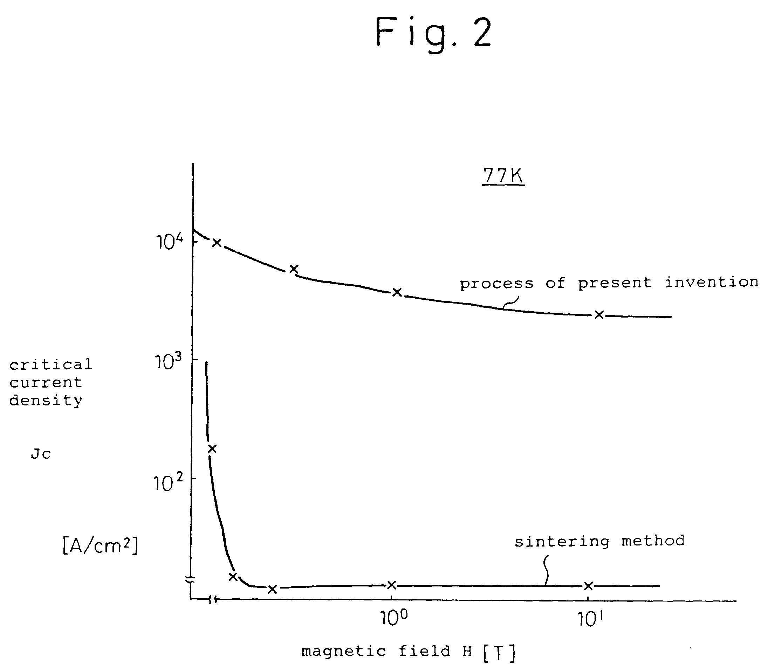

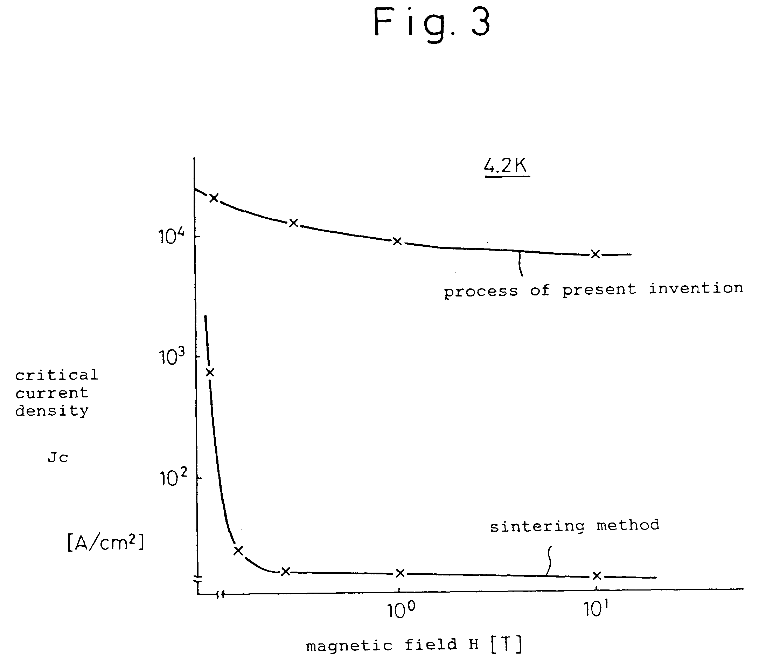

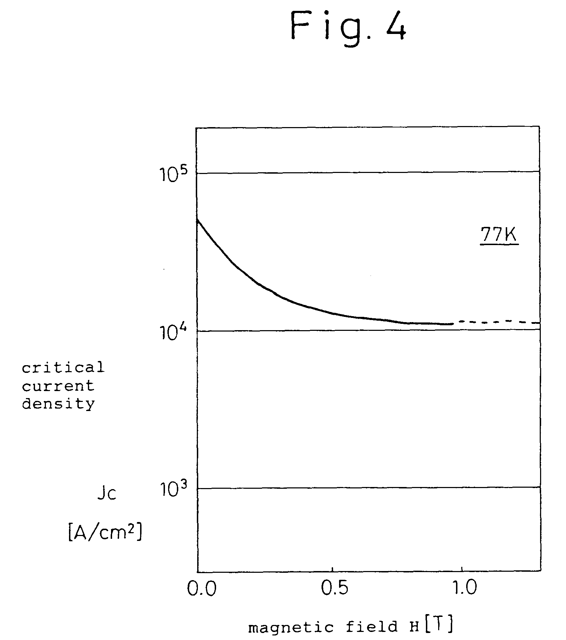

The transport critical current densities determined at 4.2 K and 77 K by the four-terminal method are shown in Figs. 2 and 3 (the four-terminal method includes a risk of an underestimation of the Jc by a generation of heat at the current terminal). Figure 4 shows the critical current density determined by the measurement of magnetization characteristics of another sample. It was confirmed that, in this case, a value larger than the value obtained by the four-terminal method was obtained.

As apparent from the foregoing results, the preparation process of the present invention is far superior to that of the conventional preparation process, in that a superconductive material having a high quality can be prepared.

When the experiment was similarly carried out in the state in which the plate was placed on a bent platinum net, it was confirmed that a shape substantially the same as the shape of the net could be imparted to the superconductive material. When the experiment was similarly carried out in the state in which two plates were partially piled, it was confirmed that the superconductivity was not substantially changed in the bonded portion, and that the bondability was very good.

In connection with the mechanical characteristics, from the results of the observation of the texture, it was found that large quantities of the 211 phase having a size of about 1 µm were present in the material and the texture was fine, and the strain by the phase transition to the rhombic system from the tetragonal system was moderated without a formation of a twin crystal, and therefore, it was construed that the mechanical toughness was improved.

### INDUSTRIAL APPLICABILITY

As apparent from the foregoing detailed description, an oxide superconductive material having a high quality not obtainable according to the conventional technique can be prepared according to the present invention, and this superconductive material can be broadly used in the form of a molded article in various fields, and very high industrial effects can be obtained. The following examples can be mentioned.

### 1) Superconducting wire

According to the preparation process of the present invention, a wire having a high Jc can be prepared from a linear molded body, and the connection of this wire can be performed very easily. Accordingly, the wire can be used even as a long-distance power-transmission line.

### 2) Superconductive coil

A magnet having a high quality can be prepared only by piling many spiral molded bodies and heat-treating them in the state in which they are in contact with one another at the portions to be bonded.

### 3) Superconductive magnetic shielding material

A superconductive material having an optional shape can be prepared only by placing a plate-shaped molded body on a mold having an optional shape and heat-treating the molded body, and therefore, a high quality magnetic shielding material having a reduced flux leakage can be easily prepared.

## Claims

1. An oxide superconductive material composed of oxide of RE (a rare earth element including Y), Ba and Cu, which has a micro structure in which grains of a RE₂BaCuO₅ phase having a diameter smaller than 20 µm are dispersed in a single crystal of a REBa₂Cu₃O_{7-y} phase.

2. A process for the preparation of an oxide superconductive material, which comprises melting oxides of RE (a rare earth element including Y), Ba and Cu having a superconductive substance-forming composition, rapidly cooling and solidifying the melt to form a plate or wire, once heating the plate or wire at a high temperature of 1000 to 1350°C to produce a partially melted state, and thereafter, gradually cooling the plate or wire at a rate lower than 200°C/hr.

3. A process for the preparation of an oxide superconductive material, which comprises molding an oxide having a superconductive substance-forming composition, which is obtained by mixing RE₂O₃ (RE represents a rare earth element including Y) and BaCu oxide, into a plate,or wire, heating the molded body at a high temperature of 1000 to 1350°C to produce a partially melted state, and gradually cooling the molded body at a rate lower than 200°C/hr.

4. A process according to claim 2, wherein the thickness of the plate or wire is smaller than 5 mm.

5. A process according to claim 3, wherein the thickness of the molded body is smaller than 5 mm.

## Patentansprüche

1. Supraleitendes Oxidmaterial, das aus einem Oxid von RE (Element der Seltenen Erden, einschließlich Y), Ba und Cu besteht, das eine Mikrostruktur aufweist, bei der die Körner der RE₂BaCuO₅-Phase mit einem Durchmesser von weniger als 20 µm in einem Einkristall der REBa₂Cu₃O_{7-y}-Phase dispergiert sind.

2. Verfahren zur Herstellung eines supraleitenden Oxidmaterials, welches umfaßt: Schmelzen der Oxide von RE (ein Element der Seltenen Erden, einschließlich Y), Ba und Cu mit einer eine supraleitende Substanz bildenden Zusammensetzung, schnelles Abkühlen und Verfestigen der Schmelze, wodurch eine Platte oder ein Draht hergestellt wird, sofortiges Erwärmen der Platte oder des Drahtes auf eine hohe Temperatur von 1000 bis 1350°C, wodurch der teilweise geschmolzene Zustand erzeugt wird, und anschließendes allmähliches Abkühlen der Platte oder des Drahtes bei einer Geschwindigkeit von weniger als 200°C/h.

3. Verfahren zur Herstellung eines supraleitenden Oxidmaterials, welches umfaßt: Formen eines Oxids mit einer eine supraleitende Substanz bildenden Zusammensetzung, die durch Mischen von RE₂O₃ (wobei RE ein Element der Seltenen Erden, einschließlich Y, darstellt) und eines BaCu-Oxids erhalten wird, zu einer Platte oder einem Draht, Erwärmen des Formkörpers auf eine hohe Temperatur von 1000 bis 1350°C, wodurch ein teilweise geschmolzener Zustand erzeugt wird, und allmähliches Abkühlen des Formkörpers bei einer Geschwindigkeit von weniger als 200°C/h.

4. Verfahren nach Anspruch 2, wobei die Dicke der Platte oder des Drahtes weniger als 5 mm beträgt.

5. Verfahren nach Anspruch 3, wobei die Dicke des Formkörpers weniger als 5 mm beträgt.

## Revendications

1. Oxyde supraconducteur composé d'un oxyde de RE (élément de terre rare incluant Y), Ba et Cu, qui a une microstructure dans laquelle des grains d'une phase RE₂BaCuO₅ ayant un diamètre inférieur à 20 µm sont dispersés dans un monocristal de la phase REBa₂Cu₃O_{7-y}.

2. Procédé de préparation d'un oxyde supraconducteur, dans lequel on fait fondre des oxydes de RE (élément de terre rare incluant Y), Ba et Cu ayant une composition formant une substance supraconductrice, on refroidit rapidement et on solidifie la masse fondue pour former une plaque ou un fil, on chauffe une fois la plaque ou le fil à une température élevée de 1000 à 1350°C pour fournir un état partiellement fondu, puis on refroidit graduellement la plaque ou le fil à une vitesse inférieure à 200°C/h.

3. Procédé de préparation d'un oxyde supraconducteur, dans lequel on fait fondre un oxyde ayant une composition formant une substance supraconductrice, que l'on obtient en mélangeant RE₂O₃ (RE représente un élément de terre rare incluant Y) et un oxyde de BaCu, en une plaque ou un fil, on chauffe le corps fondu à une température élevée de 1000 à 1350°C pour fournir un état partiellement fondu, et on refroidit graduellement le corps fondu à une vitesse inférieure à 200°C/h.

4. Procédé selon la revendication 2, dans lequel l'épaisseur de la plaque ou du fil est inférieure à 5 mm.

5. Procédé selon la revendication 3, dans lequel l'épaisseur du corps fondu est inférieure à 5 mm.
